# FASCICULE DE BREVET EUROPEEN

(11) **EP 3 472 633 B1**
(45) Date de publication et mention de la délivrance du brevet: **03.08.2022**
(21) Numéro de dépôt: 17730710.5
(22) Date de dépôt: 01.06.2017
(51) Int. Cl.: G01R 31/28, H01L 21/68

(54) **DISPOSITIF DE POSITIONNEMENT D'UNE PLAQUETTE DE CIRCUIT INTEGRE, ET APPAREIL D'INSPECTION D'UNE PLAQUETTE DE CIRCUIT INTEGRE COMPRENANT UN TEL DISPOSITIF DE POSITIONNEMENT**
POSITIONIERUNGSVORRICHTUNG FÜR EINE INTEGRIERTE LEITERPLATTE UND INSPEKTIONSVORRICHTUNG FÜR EINE INTEGRIERTE LEITERPLATTE MIT SOLCH EINER POSITIONIERUNGSVORRICHTUNG
POSITIONING DEVICE FOR AN INTEGRATED CIRCUIT BOARD, AND INSPECTION APPARATUS FOR AN INTEGRATED CIRCUIT BOARD COMPRISING SUCH A POSITIONING DEVICE

(30) Priorité: 17.06.2016 FR 1655670
(43) Date de publication de la demande: 24.04.2019
(73) Titulaire: Unity Semiconductor, 38330 Montbonnot-Saint-Martin (FR)
(72) Inventeur: PETITGRAND, Sylvain, 30132 Caissargues (FR)
(74) Mandataire: IPAZ
(86) Numéro de dépôt international: PCT/EP2017/063352
(87) Numéro de publication internationale: WO 2017/215941

(56) Documents cités:
- US-A- 5 901 829
- US-A1- 2002 005 166
- US-A1- 2002 104 229
- US-A1- 2007 139 642
- US-B1- 6 183 189

## Description

### Domaine technique

La présente invention concerne un dispositif de positionnement d'une plaquette de circuit intégré, en particulier en vue de l'inspection de ladite plaquette de circuit intégré dans un appareil d'inspection. Elle concerne également un appareil d'inspection d'une plaquette de circuit intégré, tel que par exemple un appareil de profilométrie optique, comprenant un tel dispositif.

Le domaine de l'invention est plus particulièrement, mais de manière non limitative, celui des appareils d'inspection pour l'industrie de la microélectronique et de l'optique intégrée.

### Etat de la technique

Les circuits intégrés électroniques ou optiques sont en général réalisés sous la forme de plaquettes de circuit intégré.

Une plaquette de circuit intégré peut comprendre un wafer, qui est une tranche ou une galette de matériau semi-conducteur et/ou diélectrique sur la surface duquel on réalise, notamment par des opérations de dépôt ou de gravure, des motifs et des éléments de circuits intégrés.

Une plaquette de circuit intégré peut également comprendre, suivant les étapes de fabrication, par exemple :
- des éléments de wafers, ou des parties de wafer découpées, placées sur un support tel qu'un autre wafer ou un film ;
- des empilements de circuits intégrés préalablement réalisés ; ou
- des structures composites avec des circuits intégrés et des éléments de connexion dans une matrice commune.

Au cours des étapes de fabrication, il est souvent nécessaire d'inspecter une ou les surfaces de la plaquette de circuit intégré en vue par exemple de caractériser ou valider les motifs réalisés sur ladite surface, de contrôler l'épaisseur de la plaquette, etc. En particulier, il peut être nécessaire de déterminer si des tranchées ou des marches réalisées sur une face de la plaquette présentent les caractéristiques souhaitées, en termes de profondeur ou en termes de hauteur. Une telle inspection peut par exemple être réalisée par un appareil de profilométrie optique. Il peut aussi être nécessaire d'inspecter la surface d'une plaquette pour d'autres raisons avec d'autres types d'appareils.

Le document US 5 901 829 A divulgue un dispositif de positionnement d'une plaquette de circuit intégré comprenant une base supérieure et une base inférieure, un support et des moyens de positionnement dudit support. Le support décrit dans ce document ne peut être déplacé que dans le sens vertical.

Compte-tenu des dimensions très petites des motifs présents sur la surface d'une plaquette, il est nécessaire de positionner la plaquette de manière très précise, et très près du ou des capteurs utilisés pour l'inspection. De plus, lorsqu'on souhaite inspecter différentes zones de la surface, voire toute la surface, de la plaquette, il est également nécessaire de déplacer la plaquette de manière rapide par rapport aux capteurs.

Or, les dispositifs de positionnement de wafer ou de plaquettes de circuits intégrés actuellement utilisés ne permettent pas de satisfaire ces exigences.

Un but de l'invention est de remédier à cet inconvénient.

Un autre but de la présente invention est de proposer un dispositif de positionnement d'une plaquette de circuit intégré d'architecture simple et permettant un positionnement rapide et précis de ladite plaquette.

Il est aussi un but de la présente invention de proposer un dispositif de positionnement d'une plaquette d'architecture simple tout en autorisant une inspection simultanée des deux faces de la plaquette.

### Exposé de l'invention

Au moins un de ces objectifs est atteint avec un dispositif de positionnement d'une plaquette de circuit intégré selon la revendication 1.

Ainsi, le dispositif selon l'invention comprend deux bases, utilisées chacune comme référence de positionnement pour positionner la plaquette de circuit intégré dans la direction verticale. Ces deux bases sont décalées de sorte que la plaquette se trouve entre lesdites bases lors de son inspection. Ainsi, la plaquette est positionnée dans les deux sens le long de la direction verticale, ce qui permet un positionnement plus précis et plus rapide.

De plus, lors de son inspection, la plaquette se trouve entre la base supérieure et la base inférieure. Par conséquent, en équipant chaque base d'un capteur dirigé vers l'autre base, il est possible de réaliser une inspection simultanée des deux faces de la plaquette. Il est également possible de réaliser des mesures d'épaisseur de la plaquette ou des mesures en transmission d'une face à l'autre de la plaquette.

Dans la suite, le terme « inspection » peut désigner toutes opérations de mesures, de visualisation, d'imagerie, ... réalisées par des moyens optiques, électriques (capacitifs, inductifs, ...) ou acoustiques, tel que par exemple :
- des mesures d'épaisseur, de hauteur ou de profondeur sur des motifs ou des couches de la plaquette,
- des mesures de dimensions (de motifs, de structures, de zones, ... dans le plan de la plaquette,
- des visualisations d'état de surface, de présence ou d'absence d'éléments ou de motifs,
- des localisations d'éléments ou motifs, et
- des détections de défauts ou de particules.

Dans la suite, la « face inférieure » de la base supérieure est la face de la base supérieure se trouvant du côté du support mobile et de la base inférieure, la « face supérieure » de la base inférieure est la face de la base inférieure se trouvant du côté du support et de la base supérieure.

Dans la présente demande, les expressions « direction verticale » ou « direction horizontale » sont utilisées pour éviter des lourdeurs rédactionnelles et ne supposent pas d'orientation absolue dans l'espace. Tout au plus, une direction verticale est une direction perpendiculaire au plan de la plaquette et une direction horizontale est une direction parallèle au plan formé par la plaquette.

La face inférieure de la base supérieure peut être parallèle à la face supérieure de la base inférieure.

Préférentiellement, la direction verticale est la direction d'inspection de la plaquette.

En particulier, la direction verticale peut être perpendiculaire au plan formé par la plaquette lorsqu'elle est disposée dans l'emplacement d'accueil, et/ou à la face inférieure de la base supérieure, et/ou à la face supérieure de la base inférieure.

Au moins une, en particulier chaque, base peut être prévue pour accueillir, ou peut être munie de, au moins un capteur pour inspecter une face de la plaquette.

En particulier, la base supérieure peut être prévue pour accueillir, ou peut être munie de, une tête de mesure comprenant un ou plusieurs capteurs utilisés à tour de rôle ou simultanément. Une telle tête de mesure équipant la base supérieure est appelée « tête de mesure supérieure » dans la suite.

D'une manière similaire, la base inférieure peut être prévue pour accueillir, ou être munie de, une tête de mesure comprenant un ou plusieurs capteurs utilisés à tour de rôle ou simultanément. Une telle tête de mesure équipant la base inférieure est appelée « tête de mesure inférieure » dans la suite.

Dans une forme de réalisation, les têtes de mesure supérieure et inférieure peuvent être alignées en vis-à-vis l'une de l'autre, en particulier dans le plan de la plaquette.

Suivant une version préférée du dispositif selon l'invention, les bases supérieure et inférieure peuvent être décalées l'une par rapport à l'autre en outre suivant une autre direction, dite direction horizontale, perpendiculaire à la direction verticale.

Cette direction horizontale peut préférentiellement être une direction d'introduction de la plaquette entre lesdites bases.

En particulier, la direction horizontale peut être parallèle au plan formé par la plaquette lorsqu'il est disposé dans l'emplacement d'accueil, et/ou à la face inférieure de la base supérieure, et/ou à la face supérieure de la base inférieure.

En particulier, les bases peuvent se trouver à distance l'une de l'autre dans ladite direction horizontale de sorte qu'il existe un espace libre entre lesdites bases dans ladite direction horizontale.

Avantageusement, dans cette version :
- la tête de mesure supérieure peut être disposée au niveau d'un bord de ladite base supérieure proximal de la base inférieure ; et/ou
- la tête de mesure inférieure peut être disposée au niveau d'un bord de ladite base inférieur proximal de la base supérieure.

Un tel positionnement de la ou des têtes de mesure permet une architecture simple tout en offrant la possibilité d'inspecter les deux faces de la plaquette de manière simultanée. En effet, un tel positionnement permet d'inspecter les deux faces de la plaquette de manière simultanée, tout en évitant de prévoir une ouverture traversant l'une quelconque des bases supérieure et inférieure.

Suivant une caractéristique avantageuse, la distance entre les bases, dans ladite direction horizontale, peut être ajustée de sorte que les têtes de mesure sont alignées en vis-à-vis l'une de l'autre, suivant ladite direction horizontale, et plus particulièrement dans le plan de la plaquette.

Préférentiellement, les bases inférieure et supérieure peuvent être reliées entre elles de sorte à former un ensemble monobloc.

Suivant un exemple de réalisation, les bases supérieure et inférieure peuvent être reliées entre elles par deux bras de liaison, au niveau de deux bords opposés de chacune desdites bases.

Chaque bras de liaison peut se prolonger dans la direction horizontale entre la base inférieure et la base supérieure.

En particulier, les bras de liaison peuvent être parallèles entre eux.

L'ensemble monobloc, formé par les bases supérieure et inférieure, et éventuellement les bras de liaison, peut être obtenu par usinage d'une unique pièce.

Alternativement, l'ensemble monobloc peut être formé par plusieurs pièces fabriquées individuellement et assemblées entre-elles, par exemple par collage ou par vissage.

Au moins une des bases supérieure et inférieure peut être réalisée en granite ou en marbre.

Alternativement, ou en plus, au moins une des bases supérieure et inférieure peut être réalisée en un matériau métallique, ou en un matériau sensible à la force magnétique.

La face supérieure de la base inférieure, respectivement la face inférieure de la base supérieure, peut être rectifiée pour offrir une plus grande planéité ou régularité.

L'au moins un premier, respectivement l'au moins un deuxième, moyen de positionnement peut comprendre au moins un moyen d'adhésion à, ou préférentiellement de maintien avec, la base supérieure, respectivement la base inférieure, suivant la direction verticale, libre en translation suivant au moins une, en particulier toutes les, direction(s) perpendiculaire(s) à ladite direction verticale.

Préférentiellement, un tel moyen d'adhésion (ou de maintien) libre en translation peut être un moyen réalisant une adhésion (ou un maintien) sans contact avec la base. Un tel moyen d'adhésion (ou de maintien) sans contact présente un frottement nul avec la base, et donc un positionnement plus précis et plus rapide, tout en consommant moins d'énergie.

Suivant une version particulièrement avantageuse, au moins un moyen d'adhésion (ou de maintien) libre en translation peut comprendre un palier à air à vide.

Suivant une alternative, au moins un moyen d'adhésion (ou de maintien) libre en translation peut comprendre un palier à vide associé à un roulement venant contre la base.

Suivant encore une autre alternative, lorsqu'une base comprend un matériau sensible à l'attraction magnétique, au moins un moyen d'adhésion (ou de maintien) libre en translation à ladite base peut comprendre un palier à air magnétique.

Bien entendu ces exemples ne sont pas limitatifs et d'autres moyens d'adhésion libre en translation peuvent être utilisés.

Avantageusement, les premier et deuxième moyens de positionnement peuvent être disposés solidaires du support, de part et d'autre de l'emplacement d'accueil suivant une direction horizontale, perpendiculaire à la direction verticale.

Ainsi, la précision de positionnement et la stabilité du support de plaquette, et donc de la plaquette, sont améliorées.

Lorsque les bases sont décalées l'une par rapport à l'autre dans une direction horizontale, qui peut être la direction d'introduction de la plaquette entre les bases, les premier et deuxième moyens de positionnement peuvent disposés solidaires du support, de part et d'autre de l'emplacement d'accueil suivant ladite direction horizontale.

Préférentiellement, les premier et deuxième moyens de positionnement peuvent être disposés sur deux faces opposées du support, améliorant ainsi encore plus le positionnement obtenu.

En outre, l'au moins un premier, respectivement l'au moins un deuxième, moyen de positionnement peut avantageusement comprendre plusieurs moyens de positionnement.

Dans ce cas, au moins deux premiers, respectivement deux deuxièmes, moyens de positionnement peuvent avantageusement être disposés de part et d'autre de l'emplacement d'accueil suivant une direction horizontale perpendiculaire à la direction verticale. Ainsi, la précision de positionnement et la stabilité du support de plaquette, et donc de la plaquette, sont améliorées.

Cette direction horizontale est préférentiellement perpendiculaire à la direction horizontale dans laquelle les bases sont décalées l'une par rapport à l'autre, lorsqu'elles le sont.

Préférentiellement, l'emplacement d'accueil peut être, au moins en partie, ajouré de sorte à laisser accès à la plaquette qui y est disposée, du côté de chaque base.

Ainsi, il est possible d'accéder, en particulier de manière simultanée, à l'une des faces de la plaquette depuis l'une des bases et à la face opposée de la plaquette depuis l'autre des bases. Il est alors possible d'inspecter les deux faces de la plaquette en même temps.

Le dispositif selon l'invention peut avantageusement comprendre un module de déplacement, en particulier de façon motorisée, du support par rapport aux bases, réalisant une translation dudit support selon une première et une deuxième directions horizontales, perpendiculaires entre-elles et à la direction verticale.

L'une des directions horizontales peut être la direction d'introduction de la plaquette entre les bases.

Suivant un exemple de réalisation, le support peut être fixé au module de déplacement grâce à une première et une deuxième liaisons coulissantes dans ladite première direction horizontale, sensiblement parallèles entre-elles, et disposées de part et d'autre du support.

Suivant un exemple de réalisation, la première liaison coulissante peut être rigide, et la deuxième liaison coulissante peut être souple.

L'utilisation d'une liaison rigide associée à une liaison souple permet de réaliser un positionnement précis tout en absorbant, par la liaison souple, des défauts de parallélisme desdites liaisons coulissantes.

La liaison coulissante rigide peut être réalisée par une première glissière à laquelle le support peut être fixé directement ou indirectement.

La liaison coulissante souple peut être réalisée par une deuxième glissière combinée une lame ressort.

Préférentiellement, cette première direction horizontale peut être la direction horizontale dans laquelle les bases sont décalées l'une par rapport à l'autre, lorsqu'elles le sont.

Avantageusement, le support peut être fixé au module de déplacement grâce à une liaison coulissante dans la deuxième direction horizontale.

Suivant un exemple de réalisation, cette liaison coulissante peut être souple au moins dans les directions autres que la deuxième direction horizontale.

La souplesse de cette liaison coulissante permet d'absorber des défauts de planéité ou de parallélisme des bases, et en particulier de la face inférieure de la base supérieure et de la face supérieure de la base inférieure.

Cette liaison coulissante peut être réalisée par une troisième glissière combinée à une lame ressort.

Préférentiellement, le support peut être fixé au module de déplacement suivant une de ses tranches, ou un de ses bords, uniquement.

Ainsi, les autres bords/tranches du support sont libres. Autrement dit, les points de fixation du support avec le module de déplacement sont minimisés. Par conséquent, le positionnement du support par rapport à chacune des bases se fait avec plus de précision et moins de contraintes.

Suivant un exemple de réalisation, nullement limitatif, le support peut être fixé à la troisième glissière par un de ses bords, par l'intermédiaire d'une lame ressort. La troisième glissière peut être fixée :
- au niveau de l'une de ses extrémités, à la première glissière ; et
- au niveau de l'autre de ses extrémités, à la deuxième glissière par l'intermédiaire d'une lame ressort.

Le module de déplacement peut avantageusement être solidaire de l'une des bases, et/ou d'au moins l'un des bras de liaison.

Par exemple, le module de déplacement peut être fixé à la face inférieure de la base supérieure ou à la face supérieure de la base inférieure, par exemple par l'intermédiaire des première et deuxième glissières.

Alternativement, le module de déplacement peut être fixé à un bâti, par exemple d'un appareil d'inspection, sur lequel est également disposé le dispositif selon l'invention.

Suivant un autre aspect de l'invention, il est proposé un appareil d'inspection, en particulier optique, d'une plaquette de circuit intégré comprenant un dispositif de positionnement selon l'invention.

Au moins une, en particulier chaque, base du dispositif de positionnement peut être équipée d'une tête optique, en particulier amovible ou démontable, comprenant au moins un capteur.

L'appareil d'inspection peut être un appareil de caractérisation de la plaquette de circuit intégré, et plus particulièrement un appareil de mesure d'au moins un paramètre physique relatif à la plaquette de circuit intégré ou à au moins un motif présent sur une face de ladite plaquette de circuit intégré.

L'appareil d'inspection peut comprendre par exemple :
- un appareil d'interférométrie optique,
- un appareil d'imagerie de la plaquette de circuit intégré, ou
- un appareil de mesure de l'épaisseur de la plaquette de circuit intégré.

De plus l'appareil d'inspection peut réaliser une inspection d'une face d'une plaquette de circuit intégré, ou une inspection simultanée des deux faces de ladite plaquette.

### Description des figures et modes de réalisation

D'autres avantages et caractéristiques apparaîtront à l'examen de la description détaillée d'exemples nullement limitatifs, et des dessins annexés sur lesquels :
- la FIGURE 1 est une représentation schématique, selon une vue en coupe, d'un exemple de réalisation non limitatif du principe d'un dispositif selon l'invention ;
- la FIGURE 2 est une représentation schématique, selon une isométrique, d'un exemple de réalisation non limitatif de bases supérieure et inférieure pouvant être mises en œuvre dans un dispositif selon l'invention ;
- la FIGURE 3 est une représentation schématique, selon une isométrique, d'un exemple de réalisation non limitatif d'un support de wafer pouvant être mis en œuvre dans un dispositif selon l'invention ;
- les FIGURES 4a et 4b sont des représentations schématiques, selon différentes vues, d'un exemple de réalisation non limitatif d'un module de déplacement d'un support de wafer pouvant être mis en œuvre dans un dispositif selon l'invention ; et
- la FIGURE 5 est une représentation schématique d'un exemple de réalisation non limitatif d'un dispositif selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieur. Cette sélection comprend au moins une caractéristique de préférence fonctionnelle sans détail structurel, ou avec seulement une partie des détails structurels si cette partie uniquement est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

Les modes de réalisation décrits en relation avec les figures décrivent des dispositifs de positionnement destinés à positionner des wafers, étant bien entendu que de tels dispositifs peuvent être mis en œuvre pour positionner toutes sortes de plaquettes de circuits intégrés.

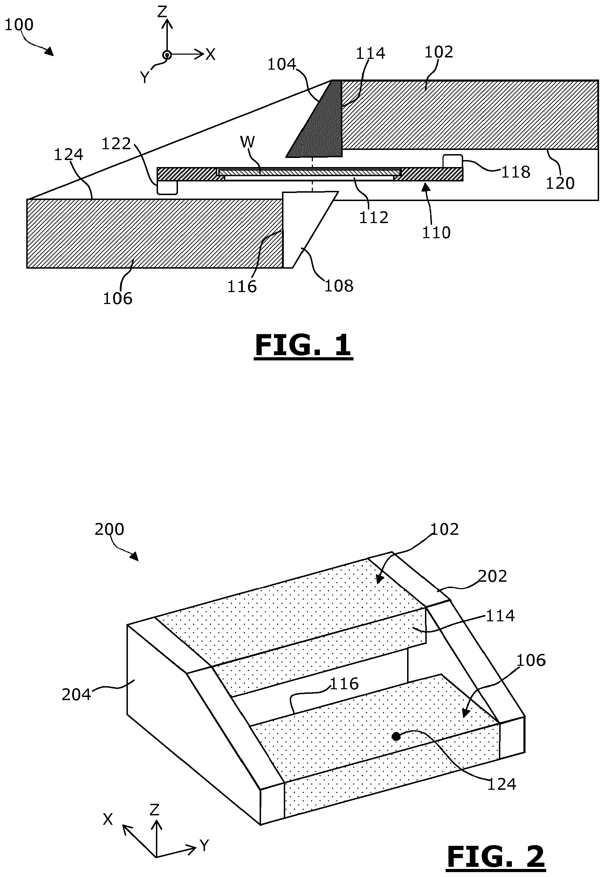

La FIGURE 1 est une représentation schématique, selon une vue en coupe, d'un exemple de réalisation non limitatif du principe d'un dispositif de positionnement selon l'invention.

Le dispositif 100, représenté sur la FIGURE 1, comprend une base 102, dite supérieure, équipée d'une tête de mesure 104, dite supérieure, comprenant au moins un capteur, en particulier optique.

Le dispositif 100 comprend en outre une base 106, dite inférieure, équipée d'une tête de mesure 108, dite inférieure, comprenant au moins un capteur, en particulier optique.

Le dispositif de positionnement 100 comprend en outre un support 110 comportant un logement d'accueil 112, ajouré, prévu pour accueillir un wafer W (ou toute autre sorte de plaquette de circuits intégrés W) à inspecter grâce aux têtes de mesures 104 et 108.

Tel que représenté sur la FIGURE 1, les bases supérieure 102 et inférieure 106 sont décalées l'une par rapport à l'autre dans une direction, dite verticale, notée « Z » sur la FIGURE 1, perpendiculaire au plan formé par le support 110. En particulier, les bases 102 et 106 se trouvent distance l'une de l'autre dans la direction Z de sorte qu'il existe un espace libre entre lesdites bases 102 et 106. Ainsi, le support de wafer 110 peut être inséré entre les bases 102 et 106, en particulier suivant une direction horizontale, notée « X » sur la FIGURE 1, perpendiculaire à la direction verticale Z et parallèle au plan formé par le support de wafer 110.

La direction verticale Z est la direction d'inspection d'un wafer W disposé dans le logement d'accueil 112 du support 110.

Toujours dans l'exemple non limitatif représenté sur la FIGURE 1, les bases supérieure 102 et inférieure 106 sont décalées l'une par rapport à l'autre dans la direction horizontale X. En particulier, les bases 102 et 106 se trouvent à distance l'une de l'autre dans la direction X de sorte qu'il existe un espace libre entre lesdites bases 102 et 106.

La tête de mesure supérieure 104 est disposée sur la base supérieure 102 du côté d'un bord 114 de la base supérieure 102 proximal de la base inférieure 106, et est dirigée vers le support 110 se trouvant entre les bases 102 et 106, suivant la direction verticale Z. De manière similaire, la tête de mesure inférieure 108 est disposée sur la base inférieure 106 du côté d'un bord 116 de la base inférieure 106 proximal de la base supérieure 102, et est dirigée vers le support 110 se trouvant entre les bases 102 et 106.

Préférentiellement, la distance entre les bases 102 et 106 est choisie de sorte que les têtes de mesures 104 et 108 sont alignées dans la direction horizontale X. De plus, les têtes de mesure 104 et 108 peuvent en outre être alignées dans une direction horizontale, notée Y, perpendiculaire aux directions X et Z, et parallèle au plan formé par le support de wafer 110. Ainsi, les têtes de mesures 104 et 108 sont alignées dans le plan perpendiculaire à la direction verticale Z, comprenant les directions horizontales X et Y, et qui correspond au plan du wafer W.

Le support 110 est muni d'un ou plusieurs premiers moyens 118 de positionnement du support 110 en référence à la base supérieure 102. En particulier, le(s) premier(s) moyen(s) de positionnement 118 réalise(nt) un positionnement du support 110 en référence à la face 120, dite inférieure, de la base supérieure 102 se trouvant du côté du support 110.

Le support 110 est en outre muni d'un ou plusieurs deuxièmes moyens 122 de positionnement du support 110 en référence à la base inférieure 106. En particulier, le(s) deuxième(s) moyen(s) de positionnement 118 réalise(nt) un positionnement du support 110 en référence à la face 124, dite supérieure, de la base inférieure 106 se trouvant du côté du support 110.

Suivant un exemple de réalisation préféré, chaque moyen de positionnement 118, respectivement 120, réalise un maintien (ou une adhésion) à distance, libre en translation, dudit support 110 avec la face 120, respectivement la face 124.

Tel que montré sur la FIGURE 1, l'au moins un premier moyen de positionnement 118 et l'au moins un deuxième moyen de positionnement se trouvent de part et d'autre du logement d'accueil 112, et donc du wafer W, dans la direction horizontale X. Ainsi, le positionnement obtenu est plus stable et plus précis.

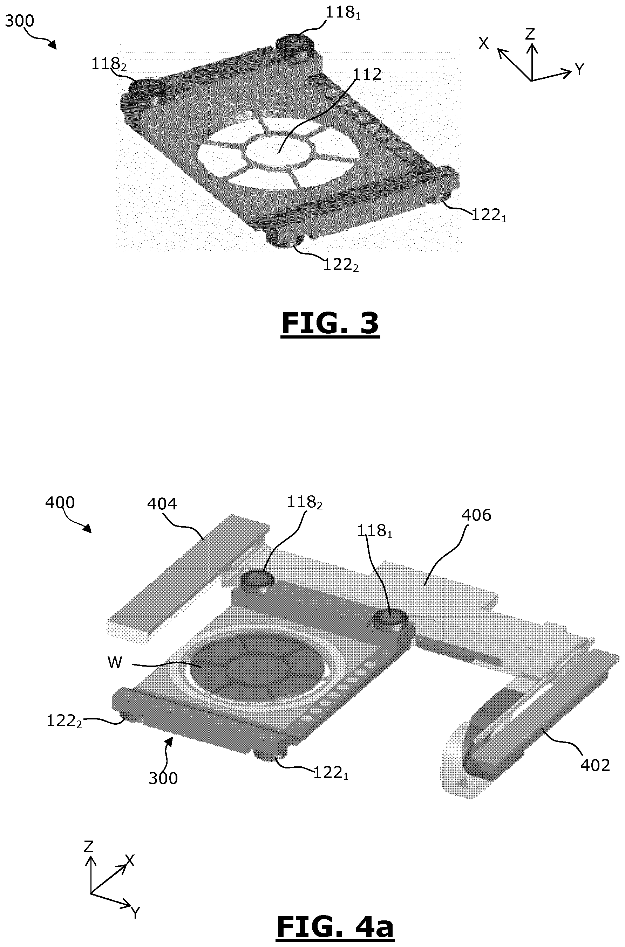

Bien entendu, le dispositif 100 comprend en outre un module déplacement du support entre les bases 102 et 106, non visible sur la FIGURE 1. Un exemple de réalisation non limitatif d'un tel module de déplacement est donné aux FIGURES 4a -4b, décrites plus loin.

Chaque base peut être réalisée en marbre ou en granite, ou encore en un matériau sensible à la force magnétique.

Préférentiellement, la face inférieure 120 de la base supérieure 102, respectivement la face supérieure 124 de la base inférieure 106 peut être rectifiée pour diminuer au maximum les défauts de planéité.

Dans l'exemple représenté sur la FIGURE 1, chacune des bases 102 et 106 est munie d'une tête de mesure, respectivement 104 et 108. Alternativement, seule l'une des bases peut être munie d'une tête de mesure.

La FIGURE 2 est une représentation schématique, selon une vue isométrique, d'un exemple de réalisation non limitatif de bases supérieure et inférieure.

Sur la FIGURE 2, seul les bases 102 et 106 sont représentées. Le support de wafer ainsi que les têtes de mesure ne sont pas représentés.

Tel que représenté sur la FIGURE 2, les bases 102 et 106 sont reliées entre-elles de sorte à former un ensemble monobloc 200.

Dans l'exemple représenté sur la FIGURE 2, les bases 102 et 106 sont reliées entre-elles par deux bras de liaison 202 et 204 se prolongeant dans la direction X entre la base supérieure 102 et la base inférieure 106. Chaque bras de liaison 202 et 204 réalise une liaison d'un bord de la base inférieure 106 avec un bord de la base supérieure 102, dans la direction X.

L'ensemble monobloc 200, représenté sur la FIGURE 2, peut être obtenu par assemblage, par exemple par collage, de plusieurs pièces réalisées indépendamment.

Alternativement, l'ensemble monobloc 200, représenté sur la FIGURE 2, peut être obtenu par usinage d'une pièce unique telle qu'un bloc de marbre ou de granite.

La FIGURE 3 est une représentation schématique, selon une vue isométrique, d'un exemple de réalisation non limitatif d'un support de wafer pouvant être utilisé dans un dispositif de positionnement selon l'invention.

Le support de wafer 300, représenté sur la FIGURE 3, peut par exemple être le support de wafer 110 de la FIGURE 1.

Le support de wafer 300 comprend deux premiers moyens de positionnement 118₁ et 118₂, disposés de part et d'autre de l'emplacement d'accueil 112 dans la direction horizontale Y. Chaque premier moyen de positionnement 118₁-118₂ est un palier à air à vide réalisant une adhésion à la face inférieure 120 de la base supérieure 102 dans les deux sens de la direction Z, tout en restant à distance de ladite face 120.

Le support de wafer 300 comprend deux deuxièmes moyens de positionnement 122₁ et 122₂, disposés de part et d'autre de l'emplacement d'accueil 112 dans la direction horizontale Y. Chaque deuxième moyen de positionnement 122₁-122₂ est un palier à air à vide réalisant une adhésion à la face supérieure 124 de la base inférieure 106 dans les deux sens de la direction Z, tout en restant à distance de ladite face 124.

Les moyens de positionnement 118₁-118₂ sont disposés sur une face du support 300 opposée à celle sur laquelle sont disposés les moyens de positionnement 122₁-122₂.

Alternativement, chaque moyen de positionnement 118₁-118₂, respectivement 122₁-122₂, peut comprendre :
- un palier à vide combiné à un roulement venant au contact de la face 120, respectivement 124 ;
- un aimant, ou un électroaimant, combiné à un roulement venant au contact de la face 120, respectivement 124 ; ou
- un aimant, ou électroaimant, combiné à un palier à air.

Le support 300 peut être réalisé en aluminium, en métal ou en plastique.

Les FIGURES 4a-4b sont des représentations schématiques d'un exemple de réalisation non limitatif d'un module de déplacement du support de wafer, pouvant être mis en œuvre dans un dispositif de positionnement selon l'invention.

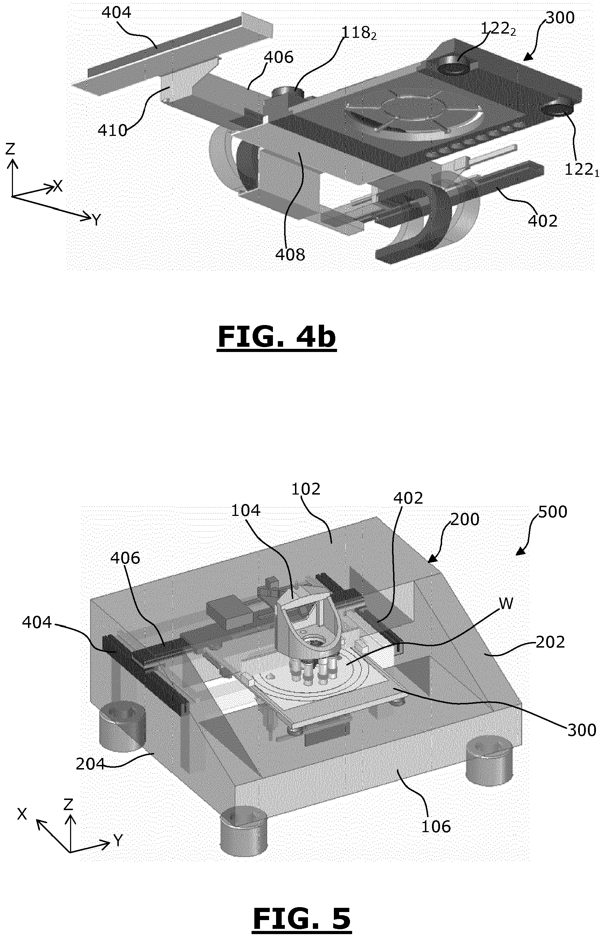

La FIGURE 4a est une représentation du module de déplacement 400, avec le support de wafer 300 de la FIGURE 3, selon une vue isométrique de dessus. La FIGURE 4b est une représentation du module de déplacement 400, avec le support de wafer 300 de la FIGURE 3, selon une vue isométrique de dessous.

Le module de déplacement 400 comprend une première et une deuxième glissières, parallèles entre-elles, et se prolongeant dans la direction horizontale X, et une troisième glissière 406 se prolongeant dans la direction horizontale Y.

Le support de wafer 300 est relié coulissante, dans la direction Y, à la troisième glissière 406, par un de ses bords, par exemple le bord se trouvant du côté des premiers moyens de positionnement 118₁-118₂. Tel que visible sur la FIGURE 4b, le support 300 est fixé à la glissière 406 par l'intermédiaire d'une lame ressort 408, autorisant une flexion dudit support 300 autour et le long de la direction Y de sorte à absorber les imperfections de planéité des faces 120 et 124.

Un moteur (non représenté), de précision micrométrique, permet de déplacer le support 300 le long de la glissière 406, dans la direction Y.

La troisième glissière 406 est fixée :
- au niveau de l'une de ses extrémités, à la première glissière 402 ; et
- au niveau de son extrémité opposée, à la deuxième glissière 404 par l'intermédiaire d'une lame ressort 410, visible sur la FIGURE 4b, permettant d'absorber des défauts de parallélisme des glissières 402 et 404.

Un moteur (non représenté), de précision micrométrique, par exemple disposé du côté de la première glissière 402, permet de déplacer l'ensemble troisième glissière 406 et support 300, le long des glissières 402 et 404, dans la direction X.

La FIGURE 5 est une représentation schématique, selon une vue isométrique, d'un exemple de réalisation non limitatif d'un dispositif selon l'invention.

Le dispositif 500 représenté sur la FIGURE 5, comprend l'ensemble monobloc 200 de la FIGURE 2, le support 300 de la FIGURE 3 et le module de déplacement 400 de la FIGURE 4.

Dans l'exemple représenté sur la FIGURE 5, le dispositif 500 comprend uniquement une tête de mesure supérieure 104, et ne comprend pas de tête de mesure inférieure.

Dans l'exemple représenté, le module de déplacement 400 est fixé, rigidement, sur les faces intérieures des bras 202 et 204 reliant les bases supérieure 102 et inférieure 106, sous la base supérieure 102.

La ou les têtes de mesure supérieures 104, et/ou inférieures 105 peuvent comprendre des éléments optiques (tels que par exemple des lentilles ou des objectifs) permettant de réaliser une ou plusieurs voies optiques de mesure et/ou d'inspection.

Suivant les modes de réalisation, ces voies optiques peuvent être superposées (avec des éléments optiques communs) pour pouvoir être utilisées simultanément, et/ou distinctes.

Les têtes de mesures supérieures 104, et/ou inférieures 105 peuvent ainsi notamment comprendre des éléments mécaniques tels qu'une tourelle porte-objectifs (comme illustré à la Fig. 5) permettant de changer les éléments optiques utilisés.

Le dispositif de positionnement selon l'invention peut être mis en œuvre dans tout appareil d'inspection d'un wafer, et plus généralement d'une plaquette de circuit intégré, comprenant par exemple :
- un profilomètre interférométrique optique permettant de faire des mesures de formes ou d'épaisseur en plein champ sur une ou les deux faces d'un wafer (ou d'une plaquette de circuit intégré) ;
- un interféromètre à faible cohérence avec une détection dans le domaine spectral ou temporel permettant de faire des mesures de distances, de hauteur ou d'épaisseur avec un faisceau de mesure dans des longueurs d'onde visible ou infrarouges ;
- un dispositif de mesure de type confocal, ou confocal chromatique ;
- un dispositif de mesure de déformation ou de distances par déflectométrie, par projection de lumière structurée ou par triangulation ;
- un dispositif d'imagerie d'une face, ou des faces, d'un wafer (ou d'une plaquette de circuit intégré) ;
- un dispositif de contrôle d'épaisseur d'un wafer (d'une plaquette de circuit intégré) ; ou
- un dispositif de détection de défauts par mesure de lumière diffusée.

Bien sûr, l'invention n'est pas limitée aux exemples qui viennent d'être décrits et de nombreux aménagements peuvent être apportés à ces exemples sans sortir du cadre de l'invention.

## Revendications

1. Dispositif (100,500) de positionnement d'une plaquette de circuit intégré (W), comprenant :
- une base (102), dite supérieure, et une base (106), dite inférieure, disposées à distance l'une de l'autre dans une direction (Z), dite verticale, de sorte à laisser un espace libre entre lesdites bases (102,106) ;
- un support (110,300), prévu mobile entre lesdites bases supérieure (102) et inférieure (106), et comportant un emplacement d'accueil (112) de ladite plaquette (W) à inspecter ;
- au moins un premier moyen de positionnement (118) dudit support (110,300) suivant ladite direction verticale (Z) contre, ou par coopération avec, ladite base supérieure (102) ; et
- au moins un deuxième moyen de positionnement (122) dudit support (110,300) suivant ladite direction verticale (Z) contre, ou par coopération avec, ladite base inférieure (106) ;
- dans lequel l'au moins un premier (118), respectivement l'au moins un deuxième (122), moyen de positionnement comprend au moins un moyen d'adhésion à la base supérieure (102), respectivement à la base inférieure (106), suivant la direction verticale (Z), libre en translation suivant au moins une, en particulier toutes les, direction(s) perpendiculaire(s) à ladite direction verticale (Z).

2. Dispositif (100,500) selon la revendication précédente, **caractérisé en ce que** les bases supérieure (102) et inférieure (106) sont décalées l'une par rapport à l'autre en outre suivant une autre direction (X), dite horizontale, perpendiculaire à la direction verticale (Z).

3. Dispositif (100,500) selon l'une quelconque des revendications précédentes, **caractérisé en ce que** les bases supérieure (102) et inférieure (106) sont reliées entre elles de sorte à former un ensemble monobloc (200).

4. Dispositif (100,500) selon l'une quelconque des revendications précédentes, **caractérisé en ce qu'**au moins une, en particulier chaque, base (102,106) est prévue pour accueillir au moins un capteur (104,108) pour inspecter une face de la plaquette (W).

5. Dispositif (100,500) selon l'une quelconque des revendications précédentes, **caractérisé en ce qu'**au moins un moyen (118,122) d'adhésion libre en translation comprend un palier à air à vide.

6. Dispositif (100,500) selon l'une quelconque des revendications précédentes, **caractérisé en ce que** les premier et deuxième moyens de positionnement (118,122) sont disposés solidaires du support (110,300), de part et d'autre de l'emplacement d'accueil (112) suivant une direction horizontale (X) perpendiculaire à la direction verticale (Z).

7. Dispositif (100,500) selon l'une quelconque des revendications précédentes, **caractérisé en ce que** l'au moins un premier (118), respectivement l'au moins un deuxième (122), moyen de positionnement comprend plusieurs moyens de positionnement, au moins deux premiers (118₁,118₂), respectivement deuxièmes (122₁,122₂), moyens de positionnement étant disposés de part et d'autre de l'emplacement d'accueil (112) suivant une direction horizontale (Y) perpendiculaire à la direction verticale (Z).

8. Dispositif (100,500) selon l'une quelconque des revendications précédentes, **caractérisé en ce que** l'emplacement d'accueil (112) est au moins en partie ajouré de sorte à laisser accès à la plaquette (W) qui y est disposée, du côté de chaque base (102,106).

9. Dispositif (100,500) selon l'une quelconque des revendications précédentes, **caractérisé en ce qu'**il comprend un module (400) de déplacement du support (300) par rapport aux bases (102,106), réalisant une translation dudit support (300) selon une première et une deuxième directions horizontales (X,Y), perpendiculaires entre-elles et à la direction verticale (Z).

10. Dispositif (100,500) selon la revendication précédente, **caractérisé en ce que** le support (300) est fixé au module de déplacement (400) grâce à une première et une deuxième liaisons coulissantes (402,404) dans ladite première direction horizontale (X), sensiblement parallèles entre-elles, disposées de part et d'autre du support (300), la première liaison coulissante (402) étant rigide, et la deuxième liaison coulissante (404) étant souple.

11. Dispositif (100,500) selon l'une quelconque des revendications 9 ou 10, **caractérisé en ce que**, dans la deuxième direction horizontale (Y), le support (300) est fixé au module de déplacement (400) grâce à une liaison coulissante souple (406).

12. Dispositif (100,500) selon l'une quelconque des revendications 9 à 11, **caractérisé en ce que** le support (300) est fixé au module de déplacement (400) suivant une de ses tranches, ou un de ses bords, uniquement.

13. Dispositif (100,500) selon l'une quelconque des revendications 9 à 12, **caractérisé en ce que** le module de déplacement (400) est solidaire de l'une des bases (102,106).

14. Appareil d'inspection, en particulier optique, d'une plaquette de circuit intégré (W), comprenant :
- un dispositif de positionnement (100,500) selon l'une quelconque des revendications précédentes, et
- au moins un capteur (104,108) solidaire d'au moins une desdites bases

## Patentansprüche

1. Vorrichtung (100, 500) zur Positionierung einer integrierten Leiterplatte (W), umfassend:
- eine so genannte obere Grundplatte (102) und eine so genannte untere Grundplatte (106), die in einer so genannten vertikalen Richtung (Z) zueinander beabstandet angeordnet sind, um einen Freiraum zwischen den Grundplatten (102, 106) zu lassen;
- eine Halterung (110, 300), die beweglich zwischen der oberen Grundplatte (102) und der unteren Grundplatte (106) vorgesehen ist und eine Stelle zur Aufnahme (112) der zu überprüfenden Platte (W) umfasst;
- mindestens ein erstes Mittel zur Positionierung (118) der Halterung (110, 300) in vertikaler Richtung (Z) an oder durch Zusammenwirken mit der oberen Grundplatte (102); und
- mindestens ein zweites Mittel zur Positionierung (122) der Halterung (110, 300) in vertikaler Richtung (Z) an oder durch Zusammenwirken mit der unteren Grundplatte (106);
- bei der das mindestens eine erste (118) bzw. das mindestens eine zweite (122) Positionierungsmittel mindestens ein Mittel zum Haften an der oberen Grundplatte (102) bzw. an der unteren Grundplatte (106) in vertikaler Richtung (Z) umfasst, das in mindestens einer, insbesondere allen Richtung(en) senkrecht zu der vertikalen Richtung (Z) in Translation frei beweglich ist.

2. Vorrichtung (100, 500) nach dem vorhergehenden Anspruch, **dadurch gekennzeichnet, dass** die obere (102) und die untere (106) Grundplatte zueinander ferner in eine weitere so genannte horizontale Richtung (X) senkrecht zu der vertikalen Richtung (Z) versetzt sind.

3. Vorrichtung (100, 500) nach einem der vorhergehenden Ansprüche, **dadurch gekennzeichnet, dass** die obere (102) und untere (106) Grundplatte miteinander verbunden sind, um eine einstückige Einheit (200) zu bilden.

4. Vorrichtung (100, 500) nach einem der vorhergehenden Ansprüche, **dadurch gekennzeichnet, dass** mindestens eine, insbesondere jede, Grundplatte (102, 106) dazu vorgesehen ist, mindestens einen Sensor (104, 108) aufzunehmen, um eine Seite der Platte (W) zu überprüfen.

5. Vorrichtung (100, 500) nach einem der vorhergehenden Ansprüche, **dadurch gekennzeichnet, dass** mindestens ein in Translation frei bewegliches Haftmittel (118, 112) ein Vakuumluftlager umfasst.

6. Vorrichtung (100, 500) nach einem der vorhergehenden Ansprüche, **dadurch gekennzeichnet, dass** die ersten und zweiten Positionierungsmittel (118, 122) mit der Halterung (110, 300) verbunden beiderseits der Aufnahmestelle (112) entlang einer horizontalen Richtung (X) senkrecht zu der vertikalen Richtung (Z) angeordnet sind.

7. Vorrichtung (100, 500) nach einem der vorhergehenden Ansprüche, **dadurch gekennzeichnet, dass** das mindestens eine erste (118) bzw. das mindestens eine zweite (122) Positionierungsmittel mehrere Positionierungsmittel umfasst, wobei mindestens zwei erste (118₁, 118₂) bzw. zweite (122₁, 122₂) Positionierungsmittel beiderseits der Aufnahmestelle (112) entlang einer horizontalen Richtung (Y) senkrecht zu der vertikalen Richtung (Z) angeordnet sind.

8. Vorrichtung (100, 500) nach einem der vorhergehenden Ansprüche, **dadurch gekennzeichnet, dass** die Aufnahmestelle (112) auf der Seite jeder Grundplatte (102, 106) zumindest teilweise gelocht ist, um Zugang zu der Platte (W), die hier angeordnet ist, zu gewähren.

9. Vorrichtung (100, 500) nach einem der vorhergehenden Ansprüche, **dadurch gekennzeichnet, dass** sie ein Modul (400) zur Verlagerung der Halterung (300) in Bezug auf die Grundplatten (102, 106) umfasst, das eine Translation der Halterung (300) entlang einer ersten und einer zweiten horizontalen Richtung (X, Y), die zueinander und zu der vertikalen Richtung (Z) senkrecht sind, durchführt.

10. Vorrichtung (100, 500) nach dem vorhergehenden Anspruch, **dadurch gekennzeichnet, dass** die Halterung (300) am Verlagerungsmodul (400) durch eine erste und eine zweite Gleitverbindung (402, 404) in die erste horizontale Richtung (X), die im Wesentlichen zueinander parallel und beiderseits der Halterung (300) angeordnet sind, befestigt ist, wobei die erste Gleitverbindung (402) starr und die zweite Gleitverbindung (404) flexibel ist.

11. Vorrichtung (100, 500) nach einem der Ansprüche 9 oder 10, **dadurch gekennzeichnet, dass** in der zweiten horizontalen Richtung (Y) die Halterung (300) am Verlagerungsmodul (400) durch eine flexible Gleitverbindung (406) befestigt ist.

12. Vorrichtung (100, 500) nach einem der Ansprüche 9 bis 11, **dadurch gekennzeichnet, dass** die Halterung (300) am Verlagerungsmodul (400) nur entlang eines ihrer Schenkel oder eines ihrer Ränder befestigt ist.

13. Vorrichtung (100, 500) nach einem der Ansprüche 9 bis 12, **dadurch gekennzeichnet, dass** das Verlagerungsmodul (400) mit einer der Grundplatten (102, 106) verbunden ist.

14. Gerät zur insbesondere optischen Überprüfung einer integrierten Leiterplatte (W), umfassend:
- eine Positionierungsvorrichtung (100, 500) nach einem der vorhergehenden Ansprüche, und
- mindestens einen Sensor (104, 108), der mit mindestens einer der Grundplatten (102, 106) verbunden ist.

## Claims

1. Device (100, 500) for positioning an integrated circuit board (W), comprising:
- a base (102), called upper, and a base (106), called lower, arranged at a distance from one another in a direction (Z), called vertical, so as to leave a free space between said bases (102, 106);
- a support (110, 300), provided to be mobile between said upper (102) and lower (106) bases, and comprising a location (112) for receiving said board (W) to be inspected;
- at least one first positioning means (118) of said support (110, 300) in said vertical direction (Z) against, or by cooperation with, said upper base (102); and
- at least one second positioning means (122) of said support (110, 300) in said vertical direction (Z) against, or by cooperation with, said lower base (106);
- wherein the at least one first (118), respectively the at least one second (122), positioning means comprises at least one means of adhesion to the upper base (102), respectively the lower base (106), in the vertical direction (Z), free in translation in at least one, in particular all, direction(s) perpendicular to said vertical direction (Z).

2. Device (100, 500) according to the preceding claim, **characterized in that** the upper (102) and lower (106) bases are offset with respect to one another in another direction (X), called horizontal, perpendicular to the vertical direction (Z).

3. Device (100, 500) according to any one of the preceding claims, **characterized in that** the upper (102) and lower (106) bases are linked together so as to form a single-piece assembly (200).

4. Device (100, 500) according to any one of the preceding claims, **characterized in that** at least one, in particular each, base (102, 106) is intended in order to receive at least one sensor (104, 108) for inspecting a face of the board (W).

5. Device (100, 500) according to any one of the preceding claims, **characterized in that** at least one adhesion means (118, 122) free in translation comprises a vacuum air bearing.

6. Device (100, 500) according to any one of the preceding claims, **characterized in that** the first and second positioning means (118, 122) are arranged secured to the support (110, 300), on each side of the receiving location (112) along a horizontal direction (X) perpendicular to the vertical direction (Y).

7. Device (100, 500) according to any one of the preceding claims, **characterized in that** the at least one first (118), respectively the at least one second (122) positioning means, comprise several positioning means, at least two first (118₁, 118₂), respectively second (122₁, 122₂) positioning means being arranged on each side of the receiving location (112) along a horizontal direction (Y) perpendicular to the vertical direction (Z).

8. Device (100, 500) according to any one of the preceding claims, **characterized in that** the receiving location (112) is at least partially perforated, so as to allow access to the board (W) which is arranged therein, on the side of each base (102, 106).

9. Device (100, 500) according to any one of the preceding claims, **characterized in that** it comprises a module (400) for displacing the support (300) with respect to the bases (102, 106), producing a translation of said support (300) in a first and a second horizontal directions (X,Y), perpendicular to one another and to the vertical direction (Z).

10. Device (100, 500) according to the preceding claim, **characterized in that** the support (300) is fixed to the displacement module (400) by means of a first and a second sliding links (402, 404) in said first horizontal direction (X), substantially parallel to one another, arranged on each side of the support (300), the first sliding link (402) being rigid, and the second sliding link (404) being flexible.

11. Device (100, 500) according to any one of claims 9 or 10, **characterized in that**, in the second horizontal direction (Y), the support (300) is fixed to the displacement module (400) by means of a flexible sliding link (406).

12. Device (100, 500) according to any one of claims 9 to 11, **characterized in that** the support (300) is fixed to the displacement module (400) along one of its rims, or one of its edges, only.

13. Device (100, 500) according to any one of claims 9 to 12, **characterized in that** the displacement module (400) is secured to one of the bases (102, 106).

14. Inspection apparatus, in particular optical, for an integrated circuit board (W), comprising:
- a positioning device (100, 500) according to any one of the preceding claims, and
- at least one sensor (104, 108) secured to at least one of said bases (102, 106).
